# EUROPEAN PATENT APPLICATION

(11) **EP 4 668 594 A1**
(43) Date of publication of application: **24.12.2025**
(21) Application number: 24183659.2
(22) Date of filing: 21.06.2024
(51) Int. Cl.: H04B 5/48

(54) **NEAR FIELD COMMUNICATION DEVICE AND OPERATING METHOD**

(71) Applicant: NXP B.V., 5656 AG Eindhoven (NL)
(72) Inventor: Feichtinger, Mark, 5656 AG Eindhoven (NL); Hrauda, Wolfgang, 5656 AG Eindhoven (NL); Mühlmann, Ulrich Andreas, 5656 AG Eindhoven (NL)
(74) Representative: Krott, Michel

(57) **Abstract**

In accordance with a first aspect of the present disclosure, a near field communication (NFC) device is provided, comprising: a receiver, said receiver including an analog-to-digital converter; a clipping detector configured to detect clipping of one or more signals processed by the analog-to-digital converter; and a sampling phase controller operatively coupled to the clipping detector, wherein said sampling phase controller is configured to adjust a sampling phase of the receiver based on an output of the clipping detector. In accordance with a second aspect of the present disclosure, a method of operating a near field communication (NFC) device is conceived.

## Description

### TECHNICAL FIELD

The present disclosure relates to a near field communication device. Furthermore, the present disclosure relates to a corresponding method of operating a near field communication device.

### BACKGROUND

Near field communication (NFC) is an established technology for proximity communication for various use cases. Using this technology, a primary device may generate a radio frequency (RF) field at a frequency of 13.56 MHz to power a secondary device. Modulation techniques are used to communicate in both directions. The secondary device may be a passive device (e.g., a tag or a transponder) or an active, typically battery-powered device. An RF field generated by an NFC reader can be used to charge the battery of the secondary device. This process is referred to as wireless charging.

### SUMMARY

In accordance with a first aspect of the present disclosure, a near field communication (NFC) device is provided, comprising: a receiver, said receiver including an analog-to-digital converter; a clipping detector configured to detect clipping of one or more signals processed by the analog-to-digital converter; and a sampling phase controller operatively coupled to the clipping detector, wherein said sampling phase controller is configured to adjust a sampling phase of the receiver based on an output of the clipping detector.

In one or more embodiments, the sampling phase controller is configured to adjust said sampling phase of the receiver during a time window between the reception of a first data frame and the reception of a second data frame.

In one or more embodiments, the NFC device further comprises a digital signal processor operatively coupled between an output of the analog-to-digital converter and an input of the clipping detector, wherein the digital signal processor is configured to derive clipping information from output signals of the analog-to-digital converter and to provide said clipping information to the clipping detector.

In one or more embodiments, the clipping detector is configured to detect the clipping of the signals processed by the analog-to-digital converter by analyzing said clipping information.

In one or more embodiments, analyzing the clipping information includes, for each of a plurality of samples taken from a given signal processed by the analog-to-digital converter, information on whether the respective sample is in clipping.

In one or more embodiments, the output of the clipping detector includes a clipping percentage which is indicative of percentage of samples which is in clipping, said samples being taken from a data frame signal processed by the analog-to-digital converter.

In one or more embodiments, the sampling phase controller is configured to adjust the sampling phase of the receiver using a predefined set of rules.

In one or more embodiments, the predefined rules contain at least the following rules: concluding that a sampling phase shift is required if an amount of clipping in an I-channel of the receiver and/or an amount of clipping in a Q-channel of the receiver exceeds a predefined threshold; if the sampling phase shift is required, and the amount of clipping in the I-channel exceeds the amount of clipping in the Q-channel, applying a first sampling phase shift; if the sampling phase shift is required, and the amount of clipping in the Q-channel exceeds the amount of clipping in the I-channel, applying a second sampling phase shift.

In one or more embodiments, the NFC device further comprises a timer configured to trigger the operation of the clipping detector after a configurable amount of time has elapsed.

In one or more embodiments, the NFC device is configured to be used for wirelessly charging an external NFC-enabled device.

In accordance with a second aspect of the present disclosure, a method of operating a near field communication (NFC) device is conceived, comprising: processing, by an analog-to-digital converter included in a receiver of the NFC device, one or more signals; detecting, by a clipping detector of the NFC device, clipping of signals processed by the analog-to-digital converter; adjusting, by a sampling phase controller of the NFC device, a sampling phase of the receiver based on an output of the clipping detector.

In one or more embodiments, the sampling phase controller adjusts said sampling phase of the receiver during a time window between the reception of a first data frame and the reception of a second data frame.

In one or more embodiments, a digital signal processor of the NFC device derives clipping information from output signals of the analog-to-digital converter and provides said clipping information to the clipping detector.

In one or more embodiments, the clipping detector detects the clipping of the signals processed by the analog-to-digital converter by analyzing said clipping information.

In one or more embodiments, analyzing the clipping information includes, for each of a plurality of samples taken from a given signal processed by the analog-to-digital converter, information on whether the respective sample is in clipping.

### DESCRIPTION OF DRAWINGS

Embodiments will be described in more detail with reference to the appended drawings.
Fig. 1 shows an example of an NFC-based wireless charging system.
Fig. 2 shows a communication from the perspective of a proximity coupling device, when receiving a data frame from a proximity integrated circuit card.
Fig. 3 shows an example of a failing communication scenario.
Fig. 4 shows an illustrative embodiment of an NFC device.
Fig. 5 shows an illustrative embodiment of a method of operating an NFC device.
Fig. 6 shows an illustrative embodiment of an NFC communication system.
Fig. 7 shows a receiver sampling phase adjustment.
Fig. 8 shows a proof-of-concept simulation.
Fig. 9 shows an illustrative embodiment of a hardware implementation.

### DESCRIPTION OF EMBODIMENTS

Typical implementations of NFC direct wireless charging make use of a WLC-P (wireless charging poller) device and a WLC-L (wireless charging listener) device. The wireless charging poller may be a standalone reader device which is configured to charge the battery of the wireless charging listener, i.e. a secondary accessory device such as a watch or fitness tracker. Basic standalone WLC-P implementations typically have a single antenna for WLC use cases. In contrast, general NFC devices and especially NFC-enabled mobile devices (such as mobile phones and tablets) can support WLC-P use cases in parallel to conventional NFC use cases (such as payment, ticketing, access control, and tag reading applications) with a single NFC controller connected to NFC and WLC antennas. In that case, time multiplexing methods may be used to enable that only one antenna is actively connected to the NFC controller's radio frequency (RF) modem (i.e., the controller's NFC transceiver). Accordingly, an NFC controller's RF modem may be connected to multiple antennas, including NFC and WLC antennas. In both cases, an NFC controller is connected to a WLC antenna through which the wireless charging operation can be performed.

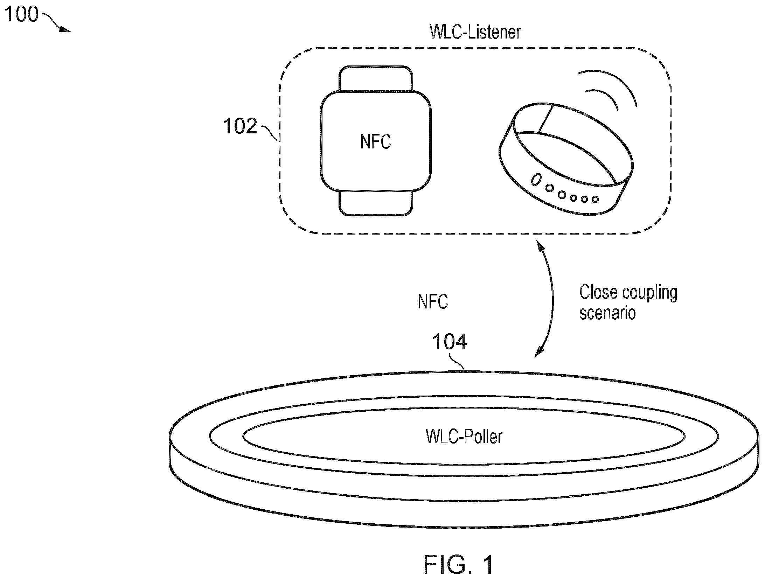

**Fig. 1** shows an example of an NFC-based wireless charging system 100. The system 100 comprises a WLC-Listener 102 coupled to a WLC-Poller 104. In NFC systems, a proximity coupling device (PCD, also be referred to as a reader) is magnetically coupled with a proximity integrated circuit card (PICC, also referred to as a tag). If the NFC system is used in a wireless charging application, the PCD is configured to act as a wireless charging device, and the PICC as an energy receiving device (i.e., a device under charge). The PCD and the PICC exchange information by modulating a radio frequency (RF) carrier signal emitted by the PCD. The NFC wireless charging (WLC) standard by NFC Forum extends the pure communication purpose of NFC to wireless charging. In this case, a WLC-Poller (WLC-P) 104 uses an NFC communication link to charge a small NFC-enabled device, called a WLC-Listener (WLC-L) 102. Hence, the NFC specification is used for controlling the wireless power charging using the same antenna and communication chain as for regular NFC.

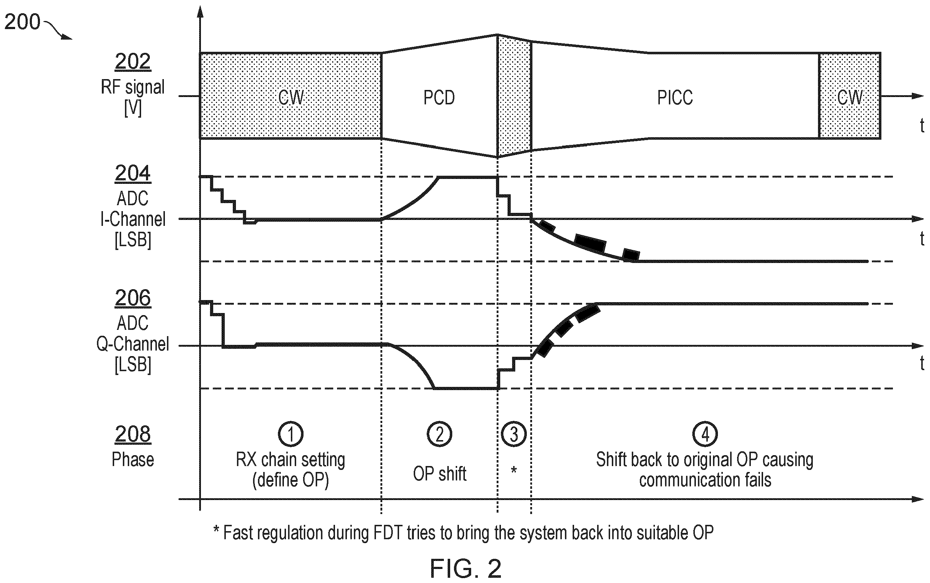

Fig. 2 shows a communication 200 from the perspective of a PCD, when receiving a data frame from a PICC. Compared to regular NFC, i.e. communication that conforms to the ISO 14443 standard, the operating distance between PCD and PICC in a wireless charging application is much smaller and the antennas are better aligned. Therefore, a higher field strength and a higher input voltage are present at the receiver (RX). The communication between the PCD and the PICC leads to loading effects. An example of these effects is shown in Fig. 2. First, the PCD emits a stable continuous wave (CW) carrier signal to power the PICC. Before the PCD sends the first command to the PICC, the RX chain settles to a suitable operation point (OP). The RX of a typical PCD assumes a stable RF signal 202. Hence the settled OP maximizes the dynamic range of the system constrained by the RX sensitivity requirements and freezes once the communication starts. Second, during the PCD command, loading effects change the phase and the amplitude of the RF signal 202. As a result, the settled OP moves away. Third, during the frame delay time (FDT), the conventional fast regulation in the PCD RX tries to re-establish a valid OP for the signal. Fourth, during the PICC signal, the loading effects ease and the system shifts back to the original OP. However, this can lead to communication fails, as the RX chain might be partially or completely saturated. A typical tracking mechanism cannot correct the existing OP fast enough to keep the signal within the dynamic range of the PCD RX. Therefore, the communication is lost.

The bottleneck in terms of dynamic range of a typical RX chain for an NFC PCD are the analog-to-digital converters (ADCs). Due to area and power optimizations in an integrated circuit (IC) it is not possible to simply increase the dynamic range to cover an additional range due to the loading effects or to increase the resolution of the ADC. Hence, the regulation would need to find an operation point which keeps the whole RX signal, including the loading effect, in the dynamic range of the ADC, for example by reducing the gain in the RX chain or lowering the received signal strength indicator (RSSI). However, this would limit the sensitivity, as the resolution of the ADC is limited.

Although most typical NFC PCDs use digital-to-analog converters (DACs), to remove constant DC offsets from the baseband signals after the RF I/Q mixer, such mechanisms have high resolution at the cost of limited speed, usually limited by the control loop to avoid oscillations. This speed limitation is especially restrictive while the PCD is receiving a frame from the PICC in close coupling scenarios, where loading effects exceed the speed of the slow regulation. Therefore, the reception will be limited.

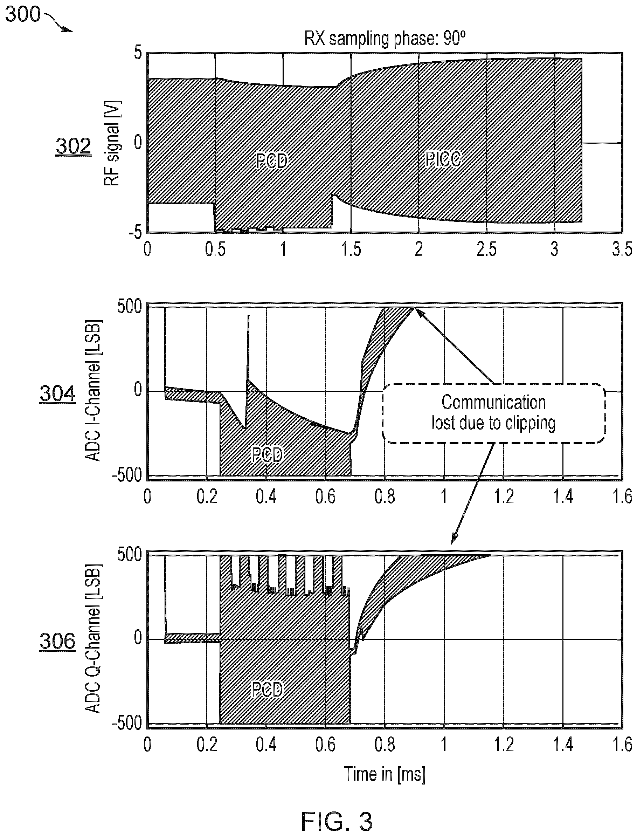

**Fig. 3** shows an example of a failing communication scenario 300. In particular, the RF signal 302 shown in Fig. 3 includes the loading effects during PCD and PICC commands and the corresponding ADC signals 304, 306. One can clearly see, that the frame signal moves out of the range of the ADC. Hence, the communication is incomplete and the communication fails. Depending on the severity of the loading effects, typical OP tracking mechanism are not fast enough to counteract this drift. The only option to keep the frame within the dynamic range of the ADC is to perform an exhaustive setting optimization. However, this would limit the sensitivity of the system, as the resolution of the ADC is fixed.

Now discussed are an NFC device and a corresponding method of operating an NFC device, which facilitate keeping the operation point of a receiver within the dynamic range of said receiver, while avoiding a complex receiver settings optimization and while avoiding a significant reduction of the receiver sensitivity.

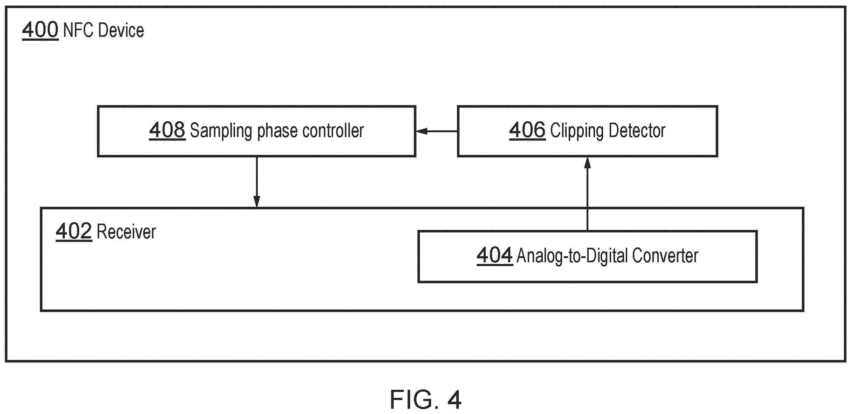

**Fig. 4** shows an illustrative embodiment of an NFC device 400. The NFC device 400 comprises a receiver 402, which in turn comprises an analog-to-digital converter 404. Furthermore, the NFC device 400 comprises a clipping detector 406, which is configured to detect clipping of one or more signals processed by the analog-to-digital converter 404. Furthermore, the NFC device 400 comprises a sampling phase controller 408 operatively coupled to the clipping detector 406, wherein said sampling phase controller 408 is configured to adjust a sampling phase of the receiver 402 based on an output of the clipping detector 406. By adjusting the sampling phase of the receiver 402 based on a detected clipping of the analog-to-digital converter 404, the operation point of the receiver 402 may easily be kept within its dynamic range, while avoiding a complex receiver settings optimization and while avoiding a significant reduction of the receiver's sensitivity. It is noted that the sampling phase of the receiver may be defined as the phase change, compared to a stable clock source, where the mixer samples the data (e.g., using sample-and-hold mixing) in order to mix the RF signal to the baseband.

In one or more embodiments, the sampling phase controller is configured to adjust said sampling phase of the receiver during a time window between the reception of a first data frame and the reception of a second data frame. In this way, it may be ensured that a next data frame in a sequence of frames is correctly received. In one or more embodiments, the NFC device further comprises a digital signal processor operatively coupled between an output of the analog-to-digital converter and an input of the clipping detector, wherein the digital signal processor is configured to derive clipping information from output signals of the analog-to-digital converter and to provide said clipping information to the clipping detector. This results in a practical implementation of the receiver sampling phase adjustment.

In one or more embodiments, the clipping detector is configured to detect the clipping of the signals processed by the analog-to-digital converter by analyzing said clipping information. In this way, the clipping of the signals processed by the analog-to-digital converter may be detected more easily. Furthermore, in one or more embodiments, analyzing the clipping information includes, for each of a plurality of samples taken from a given signal processed by the analog-to-digital converter, information on whether the respective sample is in clipping. This further facilitates the detection of the clipping of the signals processed by the analog-to-digital converter. Furthermore, in a practical implementation, the output of the clipping detector includes a clipping percentage which is indicative of percentage of samples which is in clipping, said samples being taken from a data frame signal processed by the analog-to-digital converter.

In one or more embodiments, the sampling phase controller is configured to adjust the sampling phase of the receiver using a predefined set of rules. In this way, the sampling phase of the receiver may be adjusted in a relatively simple manner, which is easy to implement. Furthermore, in a practical implementation, the predefined rules contain at least the following rules: concluding that a sampling phase shift is required if an amount of clipping in an I-channel of the receiver and/or an amount of clipping in a Q-channel of the receiver exceeds a predefined threshold; if the sampling phase shift is required, and the amount of clipping in the I-channel exceeds the amount of clipping in the Q-channel, applying a first sampling phase shift; and if the sampling phase shift is required, and the amount of clipping in the Q-channel exceeds the amount of clipping in the I-channel, applying a second sampling phase shift. In a non-limiting example, the first sampling phase shift is a negative sampling phase shift, in particular of -45°, and the second sampling phase shift is a positive sampling phase shift, in particular of +45°. The skilled person will appreciate that other sampling phase shift values may be applied, depending on the receiver architecture.

In one or more embodiments, the NFC device further comprises a timer configured to trigger the operation of the clipping detector after a configurable amount of time has elapsed. In this way, it may be ensured that the clipping detection takes into account guard times. Furthermore, in one or more embodiments, the NFC device is configured to be used for wirelessly charging an external NFC-enabled device. Thus, the presently disclosed NFC device may be used to advantage in wireless charging applications.

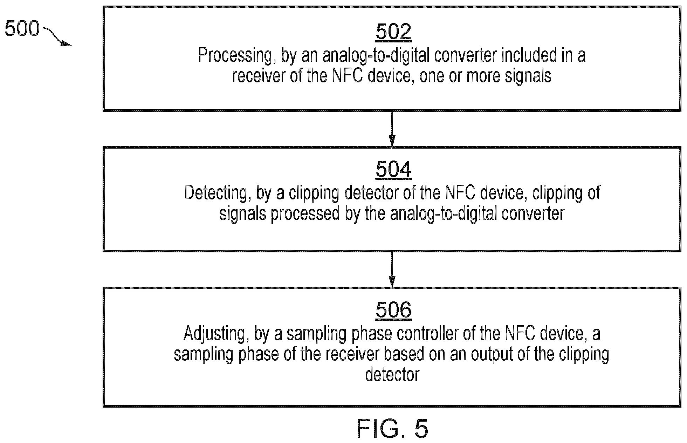

**Fig. 5** shows an illustrative embodiment of a method 500 of operating an NFC device. The method 500 comprises the following steps. At 502, an analog-to-digital converter, which is included in a receiver of the NFC device, processes one or more signals. At 504, a clipping detector of the NFC device detects clipping of signals processed by the analog-to-digital converter. Furthermore, at 506, a sampling phase controller of the NFC device adjusts a sampling phase of the receiver based on an output of the clipping detector. As explained above with reference to the corresponding NFC device shown in Fig. 4, by adjusting the sampling phase of the receiver based on a detected clipping of the analog-to-digital converter, the operation point of the receiver may easily be kept within its dynamic range, while avoiding a complex receiver settings optimization and while avoiding a significant reduction of the receiver's sensitivity.

More specifically, in some embodiments, a digitally controlled adjustment of the receiver sampling phase may have the purpose of keeping at least one of the I-channel and Q-channel of the receiver within the dynamic range of the PCD. This adjustment may be achieved by detecting saturation of the analog-to-digital converter during a received data frame (i.e., a received PICC frame), and by using the saturation information in a controller to adjust the receiver sampling phase. For this purpose, the PCD may contain a device (i.e., a clipping detector) which accurately detecting clipping of the analog-to-digital converters in both the I-channel and the Q-channel. Furthermore, the PCD may contain a receiver sampling phase controller which selects a suitable receiver sampling phase value in dependence on the clipping information (i.e., saturation information), and adjusts the receiver sampling phase according to the newly selected phase value. The phase adjustment may be carried out between two successive PICC frames, to ensure that a next PICC frame is correctly received.

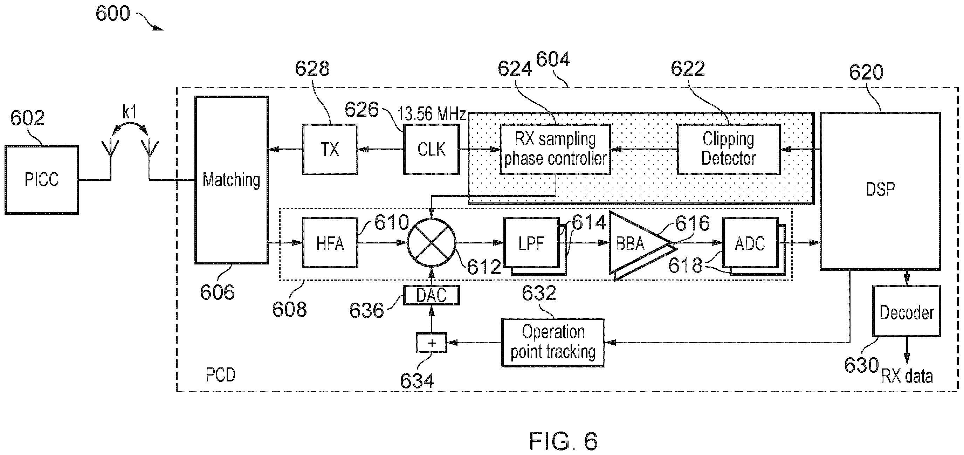

**Fig. 6** shows an illustrative embodiment of an NFC communication system 600. The system 600 comprises a PICC 602 which communicates with a PCD 604. The PCD 604 comprises a clipping detector 622 and a receiver (RX) sampling phase controller 624. In this example of an implementation, the RX sampling phase controller 624 utilizes feedback from the digital signal processor (DSP) 620 to select an optimal RX sampling phase. The clipping detector 622 measures how many samples between the start of the PICC frame and the end of the communication are in clipping and calculates a clipping percentage (*clipping_I_perc, clipping_Q_perc*)*.* Furthermore, the clipping detector 622 determines how long the reception was. In case one or both of the I-channel and Q-channel are longer in clipping than a configurable threshold (*clipping_threshold*), the controller 624 adjusts the RX sampling phase according to a specific set of rules.

In a non-limiting example, the set of rules may be as follows:
- *clipping_I_perc* > *clipping_threshold* OR *clipping_Q_perc* > *clipping_threshold* → phase shift required
- if phase shift required AND *clipping_I_perc* > *clipping_Q_perc* → RX_phase -45°
- if phase shift required AND *clipping_Q_perc* > *clipping_I_perc* → RX_phase +45°

Furthermore, the clipping detection may have to consider guard times after the reception of a start of frame (SOF), where other mechanisms (such as regulations of the HFA and BBA gain) can lead to short clipping phases. Therefore, a clipping detection threshold or a configurable timer may be used to delay the start of the clipping detection (thereby implementing a clipping detection guard time).

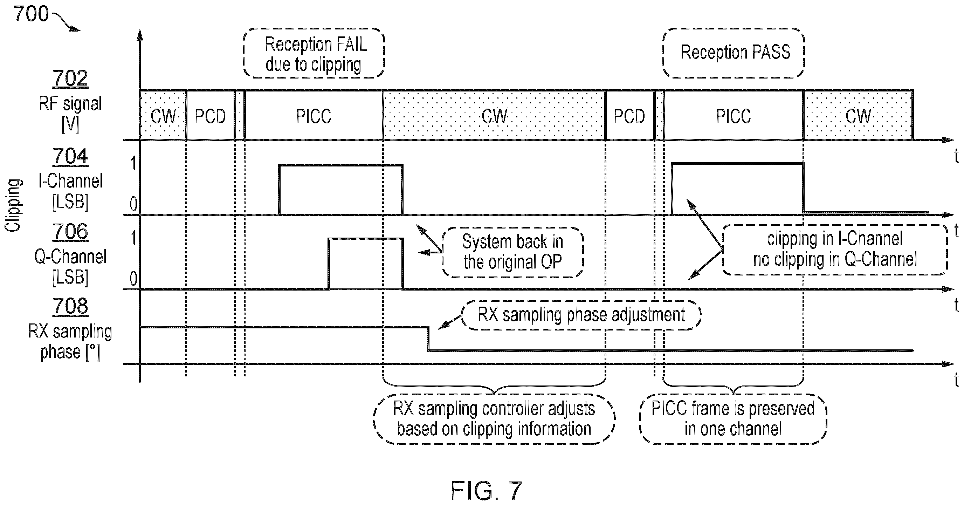

**Fig. 7** shows a receiver sampling phase adjustment 700. In particular, an example of a scenario is shown, in which both the I-channel 704 and the Q-channel 706 of the receiver clip during the reception of a PICC frame. Thus, initially the reception fails due to clipping. After the PICC frame, the signal might return to the original operation point (OP) to which the receiver settled to during the continuous wave (CW) carrier. As clipping was detected, the RX sampling controller adjusts the RX sampling phase before the next PCD command is sent (as prescribed by the retry mechanism in the technical standard ISO 14443). As a result, the I-channel 704 clips much earlier, but the Q-channel 706 does not clip at all. Hence, the PICC frame is preserved within the dynamic range of the RX and can be decoded, so that the reception passes.

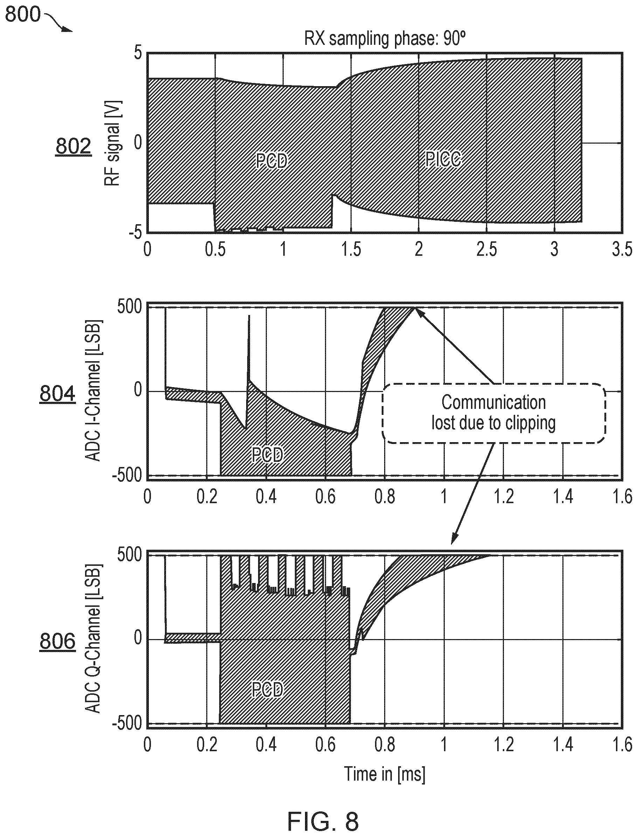

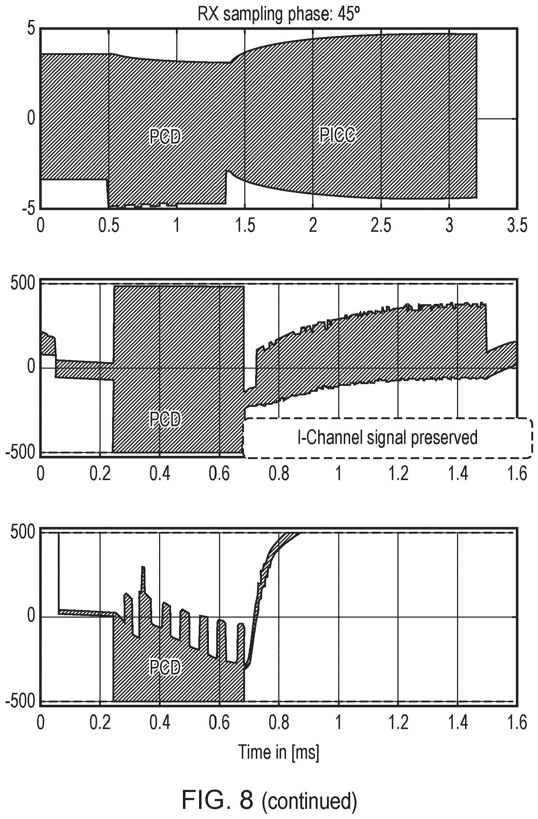

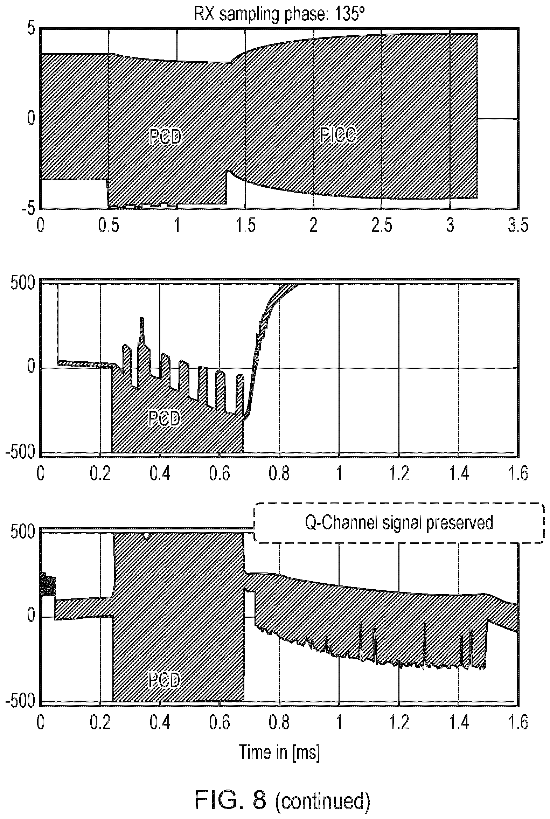

**Fig. 8** shows a proof-of-concept simulation 800. In particular, the communication scenario as shown in Fig. 3, in which a RX sampling phase of 90° is used and the communication is lost due to clipping, is shown again on the left side of Fig. 8. For the succeeding data frames, the RX sampling phase controller can optimize the RX sampling phase depending on the clipping information and the introduced rules. The column in the middle shows the result, if the RX sampling phase is moved to 45°. In that case, the I-channel 804 is preserved and decoding is possible. The column on the right shows a RX sampling phase correction to 135°. In that case, the Q-channel 806 is preserved. It is noted that the RX should settle into a new OP when the RX sampling phase is changed. Hence, the RX sampling phase correction should be the first step.

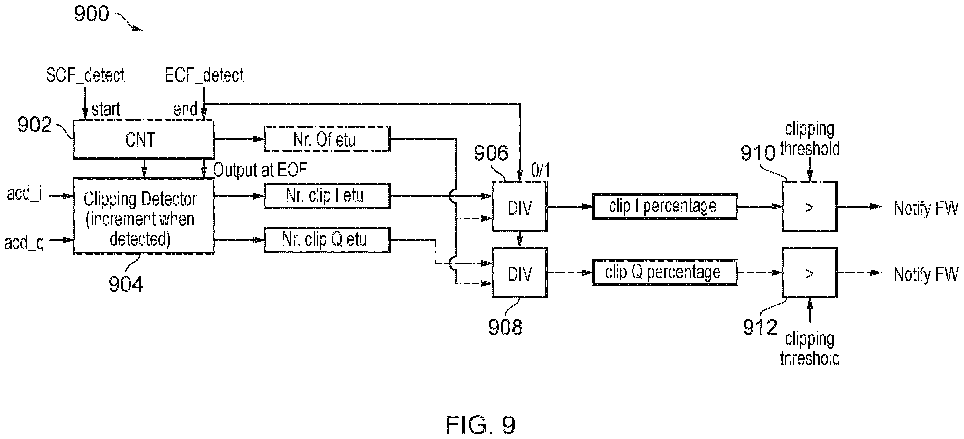

**Fig. 9** shows an illustrative embodiment of a hardware implementation 900. In particular, an example of a hardware implementation is shown, which may be replaced by software. Supported by state-of-the-art design, it is possible to implement a software (SW) solution in a contactless interface (CLIF) co-processor (CCP) without adding new hardware (HW) blocks. More specifically, in the example shown in Fig. 9, a counter 902 is started once the start of frame (SOF) plus a specified clipping detection guard time is detected. At each count, the clipping detector 904 checks whether the ADC data from the respective channels are in clipping. If so, the number of clipping samples is increased. Once the end of frame (EOF) is detected, the clipping percentage is calculated and if this percentage exceeds the clipping threshold in one or both channels, the firmware (FW) is notified to adjust the RX sampling phase using the above-described rules. The RX phase adjustment utilizes the existing RX sampling phase settings (e.g., 45° phase steps derived from a 108 MHz system clock).

It is noted that the embodiments above have been described with reference to different subject-matters. In particular, some embodiments may have been described with reference to method-type claims whereas other embodiments may have been described with reference to apparatus-type claims. However, a person skilled in the art will gather from the above that, unless otherwise indicated, in addition to any combination of features belonging to one type of subject-matter also any combination of features relating to different subject-matters, in particular a combination of features of the method-type claims and features of the apparatus-type claims, is considered to be disclosed with this document.

Furthermore, it is noted that the drawings are schematic. In different drawings, similar or identical elements are provided with the same reference signs. Furthermore, it is noted that in an effort to provide a concise description of the illustrative embodiments, implementation details which fall into the customary practice of the skilled person may not have been described. It should be appreciated that in the development of any such implementation, as in any engineering or design project, numerous implementation-specific decisions must be made in order to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill.

Finally, it is noted that the skilled person will be able to design many alternative embodiments without departing from the scope of the appended claims. In the claims, any reference sign placed between parentheses shall not be construed as limiting the claim. The word "comprise(s)" or "comprising" does not exclude the presence of elements or steps other than those listed in a claim. The word "a" or "an" preceding an element does not exclude the presence of a plurality of such elements. Measures recited in the claims may be implemented by means of hardware comprising several distinct elements and/or by means of a suitably programmed processor. In a device claim enumerating several means, several of these means may be embodied by one and the same item of hardware. The mere fact that certain measures are recited in mutually different dependent claims does not indicate that a combination of these measures cannot be used to advantage.

### LIST OF REFERENCE NUMBERS

- 100: NFC-based wireless charging system
- 102: WLC-Listener
- 104: WLC-Poller
- 200: communication from PCD perspective when receiving a PICC frame
- 202: RF signal (V)
- 204: ADC 1-channel (LSB)
- 206: ADC Q-channel (LSB)
- 208: phase
- 300: failing communication scenario
- 302: RF signal (V)
- 304: ADC 1-channel (LSB)
- 306: ADC Q-channel (LSB)
- 400: NFC device
- 402: receiver
- 404: analog-to-digital converter
- 406: clipping detector
- 408: sampling phase controller
- 500: method of operating an NFC device
- 502: processing, by an analog-to-digital converter included in a receiver of the NFC device, one or more signals
- 504: detecting, by a clipping detector of the NFC device, clipping of signals processed by the analog-to-digital converter
- 506: adjusting, by a sampling phase controller of the NFC device, a sampling phase of the receiver based on an output of the clipping detector
- 600: NFC communication system
- 602: proximity integrated circuit card
- 604: proximity coupling device
- 606: matching circuit
- 608: receiver
- 610: high-frequency attenuator
- 612: mixer
- 614: low-pass filters
- 616: baseband amplifiers
- 618: analog-to-digital converters
- 620: digital signal processor
- 622: clipping detector
- 624: receiver sampling phase controller
- 626: clock
- 628: transmitter
- 630: decoder
- 632: operation point tracking
- 634: adder
- 636: digital-to-analog converter
- 700: receiver sampling phase adjustment
- 702: RF signal (V)
- 704: 1-channel (LSB)
- 706: Q-channel (LSB)
- 708: receiver sampling phase
- 800: proof-of-concept simulation
- 802: RF signal (V)
- 804: ADC 1-channel (LSB)
- 806: ADC Q-channel (LSB)
- 900: hardware implementation
- 902: counter
- 904: clipping detector
- 906: divider
- 908: divider
- 910: comparator
- 912: comparator

## Claims

1. A near field communication, NFC, device, comprising:
a receiver, said receiver including an analog-to-digital converter;
a clipping detector configured to detect clipping of one or more signals processed by the analog-to-digital converter;
a sampling phase controller operatively coupled to the clipping detector, wherein said sampling phase controller is configured to adjust a sampling phase of the receiver based on an output of the clipping detector.

2. The NFC device of claim 1, wherein the sampling phase controller is configured to adjust said sampling phase of the receiver during a time window between the reception of a first data frame and the reception of a second data frame.

3. The NFC device of claim 1 or 2, further comprising a digital signal processor operatively coupled between an output of the analog-to-digital converter and an input of the clipping detector, wherein the digital signal processor is configured to derive clipping information from output signals of the analog-to-digital converter and to provide said clipping information to the clipping detector.

4. The NFC device of claim 3, wherein the clipping detector is configured to detect the clipping of the signals processed by the analog-to-digital converter by analyzing said clipping information.

5. The NFC device of claim 4, wherein analyzing the clipping information includes, for each of a plurality of samples taken from a given signal processed by the analog-to-digital converter, information on whether the respective sample is in clipping.

6. The NFC device of any preceding claim, wherein the output of the clipping detector includes a clipping percentage which is indicative of percentage of samples which is in clipping, said samples being taken from a data frame signal processed by the analog-to-digital converter.

7. The NFC device of any preceding claim, wherein the sampling phase controller is configured to adjust the sampling phase of the receiver using a predefined set of rules.

8. The NFC device of claim 7, wherein said predefined rules contain at least the following rules:
concluding that a sampling phase shift is required if an amount of clipping in an I-channel of the receiver and/or an amount of clipping in a Q-channel of the receiver exceeds a predefined threshold;
if the sampling phase shift is required, and the amount of clipping in the I-channel exceeds the amount of clipping in the Q-channel, applying a first sampling phase shift;
if the sampling phase shift is required, and the amount of clipping in the Q-channel exceeds the amount of clipping in the I-channel, applying a second sampling phase shift.

9. The NFC device of any preceding claim, further comprising a timer configured to trigger the operation of the clipping detector after a configurable amount of time has elapsed.

10. The NFC device of any preceding claim, being configured to be used for wirelessly charging an external NFC-enabled device.

11. A method of operating a near field communication, NFC, device, comprising:
processing, by an analog-to-digital converter included in a receiver of the NFC device, one or more signals;
detecting, by a clipping detector of the NFC device, clipping of signals processed by the analog-to-digital converter;
adjusting, by a sampling phase controller of the NFC device, a sampling phase of the receiver based on an output of the clipping detector.

12. The method of claim 11, wherein the sampling phase controller adjusts said sampling phase of the receiver during a time window between the reception of a first data frame and the reception of a second data frame.

13. The method of claim 11 or 12, wherein a digital signal processor of the NFC device derives clipping information from output signals of the analog-to-digital converter and provides said clipping information to the clipping detector.

14. The method of claim 13, wherein the clipping detector detects the clipping of the signals processed by the analog-to-digital converter by analyzing said clipping information.

15. The method of claim 14, wherein analyzing the clipping information includes, for each of a plurality of samples taken from a given signal processed by the analog-to-digital converter, information on whether the respective sample is in clipping.

## Amended claims

### Amended claims in accordance with Rule 137(2) EPC.

1. A near field communication, NFC, device (400, 604), comprising:
a receiver (402, 608), said receiver (402, 608) including an analog-to-digital converter (404, 618) and a mixer (612) coupled to an input of the analog-to-digital converter (404, 618);
a clipping detector (406, 622) configured to detect clipping of one or more signals processed by the analog-to-digital converter (404, 618);
a sampling phase controller (408, 624) operatively coupled to the clipping detector (406, 622), wherein said sampling phase controller (408, 624) is configured to adjust a sampling phase of the receiver (402, 608) based on an output of the clipping detector (406, 622), wherein the sampling phase is the phase change, compared to a stable clock source, where the mixer (612) samples data in order to mix the signals before they are processed by the analog-to-digital converter (404, 618).

2. The NFC device (400, 604) of claim 1, wherein the sampling phase controller (408, 624) is configured to adjust said sampling phase of the receiver (402, 608) during a time window between the reception of a first data frame and the reception of a second data frame.

3. The NFC device (400, 604) of claim 1 or 2, further comprising a digital signal processor (620) operatively coupled between an output of the analog-to-digital converter (404, 618) and an input of the clipping detector (406, 622), wherein the digital signal processor (620) is configured to derive clipping information from output signals of the analog-to-digital converter (404, 618) and to provide said clipping information to the clipping detector (406, 622).

4. The NFC device (400, 604) of claim 3, wherein the clipping detector (406, 622) is configured to detect the clipping of the signals processed by the analog-to-digital converter (404, 618) by analyzing said clipping information.

5. The NFC device (400, 604) of claim 4, wherein analyzing the clipping information includes, for each of a plurality of samples taken from a given signal processed by the analog-to-digital converter (404, 618), information on whether the respective sample is in clipping.

6. The NFC device (400, 604) of any preceding claim, wherein the output of the clipping detector (406, 622) includes a clipping percentage which is indicative of percentage of samples which is in clipping, said samples being taken from a data frame signal processed by the analog-to-digital converter (404, 618).

7. The NFC device (400, 604) of any preceding claim, wherein the sampling phase controller (408, 624) is configured to adjust the sampling phase of the receiver (402, 608) using a predefined set of rules.

8. The NFC device (400, 604) of claim 7, wherein said predefined rules contain at least the following rules:
concluding that a sampling phase shift is required if an amount of clipping in an I-channel of the receiver (402, 608) and/or an amount of clipping in a Q-channel of the receiver (402, 608) exceeds a predefined threshold;
if the sampling phase shift is required, and the amount of clipping in the I-channel exceeds the amount of clipping in the Q-channel, applying a first sampling phase shift;
if the sampling phase shift is required, and the amount of clipping in the Q-channel exceeds the amount of clipping in the I-channel, applying a second sampling phase shift.

9. The NFC device (400, 604) of any preceding claim, further comprising a timer configured to trigger the operation of the clipping detector (406, 622) after a configurable amount of time has elapsed.

10. The NFC device (400, 604) of any preceding claim, being configured to be used for wirelessly charging an external NFC-enabled device.

11. A method (500) of operating a near field communication, NFC, device, comprising:
processing (502), by an analog-to-digital converter included in a receiver of the NFC device, one or more signals;
detecting (504), by a clipping detector of the NFC device, clipping of signals processed by the analog-to-digital converter;
adjusting (506), by a sampling phase controller of the NFC device, a sampling phase of the receiver based on an output of the clipping detector, wherein the sampling phase is the phase change, compared to a stable clock source, where a mixer included in the receiver samples data in order to mix the signals before they are processed by the analog-to-digital converter.

12. The method (500) of claim 11, wherein the sampling phase controller adjusts (506) said sampling phase of the receiver during a time window between the reception of a first data frame and the reception of a second data frame.

13. The method (500) of claim 11 or 12, wherein a digital signal processor of the NFC device derives clipping information from output signals of the analog-to-digital converter and provides said clipping information to the clipping detector.

14. The method (500) of claim 13, wherein the clipping detector detects (504) the clipping of the signals processed by the analog-to-digital converter by analyzing said clipping information.

15. The method (500) of claim 14, wherein analyzing the clipping information includes, for each of a plurality of samples taken from a given signal processed by the analog-to-digital converter, information on whether the respective sample is in clipping.
